# EUROPÄISCHE PATENTSCHRIFT

(11) **EP 3 652 544 B1**
(45) Veröffentlichungstag und Bekanntmachung des Hinweises auf die Patenterteilung: **12.04.2023**
(21) Anmeldenummer: 18733262.2
(22) Anmeldetag: 22.06.2018
(51) Int. Cl.: G01R 1/20, H01C 3/02, G01R 15/00, G01R 19/00

(54) **KOAXIALWIDERSTAND**
COAXIAL RESISTOR
RÉSISTANCE COAXIALE

(30) Priorität: 12.07.2017 DE 102017115649
(43) Veröffentlichungstag der Anmeldung: 20.05.2020
(73) Patentinhaber: Isabellenhütte Heusler GmbH & Co. KG, 35683 Dillenburg (DE)
(72) Erfinder: HETZLER, Ullrich, 35688 Dillenburg-Oberscheld (DE)
(74) Vertreter: v. Bezold & Partner Patentanwälte - PartG mbB
(86) Internationale Anmeldenummer: PCT/EP2018/066706
(87) Internationale Veröffentlichungsnummer: WO 2019/011624

(56) Entgegenhaltungen:
- WO-A1-2007/068409
- DE-A1-102007 034 757
- DE-A1-102010 009 835
- DE-A1-102013 005 939
- FR-A5- 2 044 459
- JP-A- S6 079 275
- JP-A- 2015 072 150

## Beschreibung

Die Erfindung betrifft einen Koaxialwiderstand zur Messung eines elektrischen Stroms.

Ein derartiger Koaxialwiderstand ist beispielsweise aus WO 2007/068409 A1 (DE 10 2005 059 561 A1) bekannt und in Figur 6 dargestellt. Hierbei wird der zu messende elektrische Strom über einen rohrförmigen Hinleiter zugeführt und fließt dann in entgegengesetzter Richtung durch einen ebenfalls rohrförmigen, koaxial zu dem Hinleiter angeordneten Rückleiter zurück. Vorteilhaft an dieser Stromführung in entgegengesetzten Richtungen ist die Tatsache, dass sich die von dem elektrischen Strom erzeugten Magnetfelder in gewissen Bereichen im Inneren weitgehend aufheben. Hierbei ist der Querschnitt von Hinleiter und Rückleiter kreisrund, was jedoch bei extrem niedrigen Widerstandswerten von wenigen µOhm mit einem relativ hohen Herstellungsaufwand vor allem wegen der schwer zu montierbaren Spannungsanschlüsse und der damit verbundenen zusätzlichen Fehlerquellen verbunden ist.

Zum technischen Hintergrund der Erfindung ist auch hinzuweisen auf DE 10 2014 011 593 B4, FR 2 044 459 A5, JP S60 79275 A, DE 10 2007 034 757 A1 und DE 10 2010 009 835 A1.

Schließlich offenbart JP 2015 072 150 A einen Koaxialwiderstand gemäß dem Oberbegriff von Anspruch 1. Hierbei ist die Herstellung jedoch relativ aufwändig.

Der Erfindung liegt deshalb die Aufgabe zugrunde, einen entsprechend verbesserten Koaxialwiderstand zu schaffen.

Diese Aufgabe wird durch einen erfindungsgemäßen Koaxialwiderstand gemäß dem Hauptanspruch gelöst.

Die Erfindung sieht vor, dass der Koaxialwiderstand bei dem innen liegenden Rückleiter einen eckigen Querschnitt aufweist, was die Herstellung wesentlich vereinfacht, weil der Rückleiter dann aus eckigen Platten zusammengesetzt werden kann.

Der erfindungsgemäße Koaxialwiderstand weist zunächst in Übereinstimmung mit dem bekannten Koaxialwiderstand einen Hinleiter und einen Rückleiter zum Führen des zu messenden elektrischen Stroms auf, wobei der Hinleiter und der Rückleiter koaxial angeordnet und elektrisch in Reihe geschaltet sind, so dass der Strom in dem Hinleiter und in dem Rückleiter in entgegengesetzten Stromflussrichtungen fließt. Diese Stromführung in entgegen gesetzten Richtungen ist - wie bereits eingangs zum Stand der Technik erwähnt - vorteilhaft, weil sich dadurch die von dem elektrischen Strom in Hinleiter und Rückleiter erzeugten Magnetfelder im Bereich des eigentlichen Widerstandselementes (siehe unten) weitgehend aufheben.

Darüber hinaus umfasst der erfindungsgemäße Koaxialwiderstand in Übereinstimmung mit dem bekannten Koaxialwiderstand ein Widerstandselement aus einem Widerstandsmaterial (z.B. Kupfer-Mangan-Nickel-Legierung) auf, wobei das Widerstandselement in dem Hinleiter oder in dem Rückleiter angeordnet ist, so dass der Strom durch das Widerstandselement fließt. Die über dem Widerstandselement abfallende elektrische Spannung ist entsprechend dem Ohm'schen Gesetz proportional zu dem elektrischen Strom und bildet deshalb ein Maß für den zu messenden elektrischen Strom. Dies ermöglicht eine Strommessung gemäß der Vierleitertechnik, die beispielsweise auch aus EP 0 605 800 A1 bekannt ist.

Der erfindungsgemäße Koaxialwiderstand unterscheidet sich nun von dem eingangs beschriebenen bekannten Koaxialwiderstand dadurch, dass der Querschnitt des innenliegenden Rückleiters in einer Schnittebene rechtwinklig zu der Stromflussrichtung eckig ist, insbesondere rechteckig. In einem bevorzugten Ausführungsbeispiel der Erfindung ist der Querschnitt des Rückleiters quadratisch, jedoch kann der Querschnitt auch andere Rechteckformen haben. Darüber hinaus besteht im Rahmen der Erfindung auch die Möglichkeit, dass der Querschnitt des Rückleiters dreieckig, fünfeckig oder allgemein vieleckig ist. Der eckige Querschnitt bietet - wie bereits vorstehend kurz erwähnt - den Vorteil, dass der Rückleiter aus mehreren ebenen Platten zusammengesetzt werden kann, wodurch die Herstellung des erfindungsgemäßen Koaxialwiderstands wesentlich vereinfacht wird.

Bei dem erfindungsgemäßen Koaxialwiderstand besteht der Rückleiter und auch der Hinleiter also aus mehreren ebenen, vorzugsweise rechteckigen Platten, die zu dem Hinleiter bzw. zu dem Rückleiter zusammengesetzt werden können.

Gemäß der Erfindung sind sowohl der Hinleiter als auch der Rückleiter aus Platten zusammengesetzt. Hierbei liegt jeweils eine Platte des Hinleiters parallel zu einer Platte des Rückleiters. Erfindungsgemäß haben also sowohl der Rückleiter als auch der Hinleiter einen eckigen Querschnitt.

Das vorstehend erwähnte Widerstandselement kann hierbei wahlweise in dem außenliegenden Hinleiter oder in dem innenliegenden Rückleiter angeordnet sein. Entscheidend ist lediglich, dass das Widerstandselement von dem zu messenden elektrischen Strom durchströmt wird, so dass der Spannungsabfall über dem Widerstandselement entsprechend dem Ohm'schen Gesetz ein Maß für den zu messenden elektrischen Strom bildet.

In dem bevorzugten Ausführungsbeispiel der Erfindung ist das Widerstandselement jedoch in dem innenliegenden Rückleiter angeordnet. Dies ist vorteilhaft, weil dadurch die Spannungsmessung an dem Widerstandselement im magnetfeldfreien Raum durch eine innerhalb des Koaxialwiderstands liegende Messschaltung vereinfacht wird, wie noch detailliert beschrieben wird.

In dem bevorzugten Ausführungsbeispiel der Erfindung sind die beiden Anschlussteile zur Stromzuführung bzw. Stromabführung sowie Hin- und Rückleiter aus massiven Cu-Platten hergestellt, um die bei hohen Strömen unvermeidliche Verlustleistung in den Zuleitungen zu minimieren.

In dem bevorzugten Ausführungsbeispiel der Erfindung ist das Widerstandselement jeweils in einem Einlegeteil angeordnet, wobei das Einlegeteil in den Hinleiter oder Rückleiter eingelegt ist und einen quer zur Stromflussrichtung verlaufenden Spalt in dem Hinleiter oder dem Rückleiter überdrückt. Der zu messende elektrische Strom fließt hierbei also durch das Einlegeteil, welches das Widerstandselement enthält, wobei der quer zur Stromflussrichtung verlaufende Spalt in dem Hinleiter bzw. dem Rückleiter einen unerwünschten Nebenschluss vorbei an dem Einlegeteil verhindert.

Das Einlegeteil mit dem Widerstandselement besteht vorzugsweise aus einer Verbundmaterialplatte mit zwei plattenförmigen Leiterelementen aus einem Leitermaterial (z.B. Kupfer) und dem in Stromflussrichtung dazwischen liegenden plattenförmigen Widerstandselement aus dem Widerstandsmaterial (z.B. Kupfer-Mangan-Nickel-Legierung). Derartige Verbundmaterialplatten sind beispielsweise aus EP 0 605 800 A1 bekannt und können kostengünstig aus einem Verbundmaterialband hergestellt werden.

Darüber hinaus umfasst der erfindungsgemäße Koaxialwiderstand vorzugsweise plattenförmige Anschlussteile aus einem Leitermaterial (z.B. Kupfer) zum Zuführen bzw. Abführen des zu messenden elektrischen Stroms, wobei Hinleiter und Rückleiter jeweils mit einem der beiden Anschlussteile verbunden sind.

Die elektrische Verbindung zwischen dem Hinleiter und dem Rückleiter einerseits und den Anschlussteilen andererseits kann beispielsweise durch eine Lötverbindung (z.B. Hartlötverbindung) oder eine Schweißverbindung erfolgen. Darüber hinaus können auch Hinleiter und Rückleiter sowie die Einlegeteile durch eine Lötverbindung (z.B. Hartlötverbindung) oder eine Schweißverbindung miteinander verbunden werden, um die gewünschte Reihenschaltung von Hinleiter und Rückleiter zu erreichen.

Es wurde bereits vorstehend kurz erwähnt, dass die beiden Anschlussteile zur Stromzuführung bzw. Stromabführung aus ebenen, vorzugsweise rechteckigen Platten bestehen. Ergänzend ist zu bemerken, dass diese plattenförmigen Anschlussteile vorzugsweise rechtwinklig ausgerichtet sind zu dem Hinleiter und dem Rückleiter. Darüber hinaus ist zu bemerken, dass die plattenförmigen Anschlussteile zur Stromzuführung bzw. Stromabführung vorzugsweise parallel zueinander angeordnet sind. Hinleiter und Rückleiter können also quasi auf die plattenförmigen Anschlussteile aufgesetzt werden.

Es wurde bereits vorstehend erwähnt, dass der Spannungsabfall über dem Widerstandselement gemäß dem Ohm'schen Gesetz ein Maß für den zu messenden elektrischen Strom ist. Zur Messung dieses Spannungsabfalls ist deshalb vorzugsweise mindestens ein Paar von Spannungsabgriffen vorgesehen, wobei der eine Spannungsabgriff vorzugsweise das spannungsseitige Leiterelement des Einlegeteils kontaktiert, während der andere Spannungsabgriff des Paars das masseseitige Leiterelement des Einlegeteils kontaktiert.

In dem bevorzugten Ausführungsbeispiel ist jedoch nicht nur ein einziges Paar von Spannungsabgriffen vorgesehen, sondern mehrere Paare von Spannungsabgriffen, die räumlich verteilt angeordnet sind. Jedes Paar von Spannungsabgriffen liefert also einen Spannungsmesswert, wobei aus den verschiedenen Spannungsmesswerten dann ein Mittelwert berechnet werden kann. Auf diese Weise können Inhomogenitäten der Stromverteilung in dem Koaxialwiderstand berücksichtigt werden. Grundsätzlich ist dieses Prinzip der Spannungsmessung an verschiedenen Stellen aus DE 10 2013 005 939 A1 bekannt.

Die Spannungsabgriffe können hierbei spannungsseitig oder masseseitig mindestens zwei Kontakte aus einem Leitermaterial (d.h. Doppelabgriffe) aufweisen, um einen guten Wärmekontakt mit einer Leiterplatte zu erreichen. Dies ist vorteilhaft für die Kompensation von unerwünschten Thermospannungen.

Die Verbindung zwischen den Spannungsabgriffen einerseits und den Leiterelementen der Verbundmaterialplatten (Einlegeteile) andererseits kann beispielsweise durch eine Lötverbindung (z.B. Hartlötverbindung), eine Schweißverbindung oder eine Sinterverbindung erfolgen.

Weiterhin ist zu erwähnen, dass die Spannungsabgriffe aus Kupfer bestehen können oder aus demselben Verbundmaterial wie das Einlegeteil, insbesondere aus derselben Charge.

Zur Bildung der spannungsseitigen Abgriffe bzw. der masseseitigen Spannungsabgriffe kann im Rahmen der Erfindung jeweils ein Stanzteil vorgesehen sein, das mit dem spannungsseitigen bzw. masseseitigen Leiterelement des Einlegeteils (Verbundmaterialplatte) verbunden ist.

Zur elektrischen Verbindung mit einer Leiterplatte können die Stanzteile Kontaktfahnen aufweisen, die auch biegbar sein können. In der bevorzugten Ausführungsform ist es vorteilhaft, wenn bei einem Paar der Spannungsabgriffe aus einem Leitermaterial eine masseseitige schmale und eventuell auch dünnere Kontaktfahne aus Verbundmaterial mittig zwischen zwei spannungsseitigen Kontaktfahnen angeordnet ist. Dies hat den Vorteil, dass die Temperatur der High-Seite (Spannungsseite) über die gute Wärmeleitung wegen des deutlich größeren Querschnittes der Kontaktfahnen (doppelt, dicker, breiter und bessere Wärmeleitfähigkeit) effektiv auf die Leiterplatte übertragen wird, so dass die Temperatur an den Lötstellen der Leiterplatte gleich ist mit der Temperatur der spannungsseitigen Lötstelle des Einlegeteiles. Damit liegt über der Verbundmaterialfahne die volle Temperaturdifferenz des Shunts an, so dass die Temperaturspannungskompensation korrekt funktionieren kann.

Die Stanzteile sind hierbei elektrisch und mechanisch mit den Leiterelementen der Einlegeteile (Verbundmaterialplatten) verbunden. Beispielsweise kann es sich hierbei um eine Sinterverbindung, eine Lötverbindung (z.B. Hartlötverbindung) oder eine Schweißverbindung handeln. Bei einer Sinterverbindung kann diese beispielsweise mittels einer Silber-Sinterpaste realisiert werden, die zuvor strukturiert auf die aus Kupfer bestehenden Leiterelemente gedruckt und getrocknet wird. Die gesinterte Schicht kann beispielsweise aus reinem Silber bestehen und je nach Druckdichte der Sinterpaste zwischen 30µm und 70µm dick sein.

In einem bevorzugten Ausführungsbeispiel der Erfindung sind die Stanzteile ungefähr 0,3mm dick, jedoch sind im Rahmen der Erfindung auch andere Dicken der Stanzteile möglich.

Hierbei ist auch zu erwähnen, dass zumindest ein (z.B. das masseseitige) Stanzteil und die zugehörigen Verbundmaterialplatten (Einlegeteile) vorzugsweise aus demselben Verbundmaterial bestehen, insbesondere aus derselben Charge eines Verbundmaterialbands. Dies ist vorteilhaft zur Kompensation von Thermospannungen.

Es wurde bereits vorstehend kurz erwähnt, dass die über dem Widerstandselement abfallende elektrische Spannung entsprechend dem Ohm'schen Gesetz ein Maß bildet für den zu messenden elektrischen Strom. Zur Messung dieses Spannungsabfalls ist vorzugsweise eine Messschaltung vorgesehen, die innen innerhalb des Rückleiters angeordnet sein kann. Vorzugsweise befindet sich diese Messschaltung auf einer Leiterplatte, die mit den Kontaktfahnen der Stanzteile verbunden ist, wobei die Leiterplatte vorzugsweise quer, insbesondere rechtwinklig, zu der Stromflussrichtung in dem Hinleiter und dem Rückleiter angeordnet ist. An ihren Stirnkanten weist diese Leiterplatte vorzugsweise Anschlüsse (z.B. Löt-Pads) zur Verbindung mit den Spannungsabgriffen auf, um den Spannungsabfall über dem Widerstandselement zu messen. Die Verbindung zwischen den Spannungsabgriffen einerseits und der Leiterplatte andererseits kann hierbei durch die bereits vorstehend erwähnten Kontaktfahnen der Stanzteile erfolgen.

Der Außenquerschnitt der Leiterplatte ist vorzugsweise an den Innenquerschnitt des innen liegenden Rückleiters angepasst, so dass die Leiterplatte den freien Innenquerschnitt des innen liegenden Rückleiters bis auf einen umlaufenden Spalt ausfüllt. Die vorstehend erwähnten Kontaktfahnen der Stanzteile können dann den umlaufenden Spalt zwischen der Leiterplatte und dem Rückleiter überbrücken und die Leiterplatte kontaktieren. Bei einem quadratischen Querschnitt des innen liegenden Rückleiters ist also vorzugsweise auch die Leiterplatte quadratisch. Bei einem dreieckigen Querschnitt des innen liegenden Rückleiters ist also vorzugsweise auch die Leiterplatte dreieckig. Jeder Platte des Rückleiters ist also vorzugsweise jeweils eine Stirnkante der Leiterplatte zugeordnet, so dass die Leiterplatte auf einfache Weise alle Einlegeteile in den Platten der Rückleiter kontaktieren kann.

Die Leiterplatte weist vorzugsweise mehrere Leiterplattenebenen auf und ist somit mehrlagig. In einer ersten Leiterplattenebene (z.B. an der Oberseite) können sich Symmetrierwiderstände befinden, wobei die Symmetrierwiderstände jeweils mit einzelnen Paaren von Spannungsabgriffen zugeordnet sind, um die einzelnen Spannungsmesswerte zu gewichten, wie es beispielsweise aus DE 10 2013 005 939 A1 bekannt ist.

Darüber hinaus kann die erste Leiterplattenebene auch einen Widerstand zur Kompensation der Temperaturabhängigkeit des Widerstandselements enthalten und/oder einen Temperaturfühler.

Eine zweite Leiterplattenebene enthält einen aus Kupfer bestehenden Widerstand, der ebenfalls zur Temperaturkompensation dient. Dieser kann beispielsweise auch aus zwei parallel geschalteten Widerständen bestehen, die eine Mittelwertbildung der beiden Messspannungen von den Doppelabgriffen ermöglichen. Darüber hinaus kann die Leiterplatte auch eine dritte und eine vierte Leiterplattenebene aufweisen. Dabei können sich beispielsweise an der Unterseite der Leiterplatte Kupferanschlussflächen zum Wärmeausgleich im Bereich der aus Kupfer bestehenden Widerstände befinden.

Die Kompensation von Thermospannungen ist beispielsweise aus DE 10 2016 008 415.4 bekannt.

Ferner ist zu erwähnen, dass der erfindungsgemäße Koaxialwiderstand vorzugsweise eine relativ große Dauerstromfestigkeit aufweist, die beispielsweise mindestens 1kA, 2kA, 3kA, 4kA oder sogar 5kA betragen kann.

Als Leitermaterial findet vorzugsweise Kupfer oder eine Kupferlegierung Anwendung. Es ist jedoch alternativ auch möglich, dass es sich bei dem Leitermaterial um Aluminium oder eine Aluminiumlegierung handelt.

Weiterhin ist zu erwähnen, dass das Leitermaterial vorzugsweise eine größere spezifische elektrische Leitfähigkeit aufweist als das Widerstandsmaterial.

Als Widerstandsmaterial kann im Rahmen der Erfindung beispielsweise eine Kupfer-Mangan-Nickel-Legierung verwendet werden, wie beispielsweise Cu82Mn12Ni4 (Manganin^{®}). Es ist jedoch alternativ auch möglich, dass als Widerstandsmaterial eine Nickel-Chrom-Legierung verwendet wird oder eine andere Widerstandslegierung.

Das Widerstandsmaterial des Widerstandselements weist jedoch vorzugsweise einen spezifischen elektrischen Widerstand auf, der im Bereich von 1·10⁻⁸ Ωm bis 50·10⁻⁷ Ωm liegt.

Der Widerstandswert des gesamten Koaxialwiderstands liegt dagegen vorzugsweise im Bereich von 0,1 µΩ bis 1 mΩ.

Ferner ist zu erwähnen, dass der Widerstandswert des Koaxialwiderstands vorzugsweise sehr temperaturkonstant ist mit einem Temperaturkoeffizienten von weniger als 500 ppm/K, 200 ppm/K oder sogar 50 ppm/K.

Andere vorteilhafte Weiterbildungen der Erfindung sind in den Unteransprüchen gekennzeichnet oder werden nachstehend zusammen mit der Beschreibung der bevorzugten Ausführungsbeispiele der Erfindung anhand der Figuren näher erläutert. Es zeigen:
- Figur 1A: eine Querschnittsansicht durch einen erfindungsgemäßen Koaxialwiderstand entlang der Schnittlinie A-A in Figur 1B,
- Figur 1B: eine Aufsicht auf den Koaxialwiderstand gemäß Figur 1A,
- Figur 1C: einen Teil des erfindungsgemäßen Koaxialwiderstands mit einem Anschlussteil und aufgesetzten Platten des Rückleiters,
- Figur 1D: eine Aufsicht auf einen plattenförmigen Rückleiter mit einem eingelegten Einlegteil,
- Figur 1E: eine Querschnittsansicht durch den Rückleiter mit dem Einlegeteil gemäß Figur 1D,
- Figur 2A: eine vereinfachte Querschnittsansicht durch das Einlegeteil mit den Stanzteilen zur Kontaktierung und einer Leiterplatte,
- Figur 2B: eine Aufsicht auf die Anordnung gemäß Figur 2A,
- Figur 3A: eine Aufsicht auf die Leiterplatte für die Messschaltung mit zwölf Paaren von Spannungsabgriffen,
- Figur 3B: eine vergrößerte Detailansicht eines Paars von Spannungsabgriffen aus Figur 3A,
- Figur 4: ein schematisches Schaltbild zur Erläuterung der Gewichtung der Spannungsmesswerte der einzelnen Paare von Spannungsabgriffen,
- Figur 5: ein vereinfachtes Schaltbild zur Erläuterung der Kompensation von Thermospannungen und der Kompensation des TKs des Widerstandselements, sowie

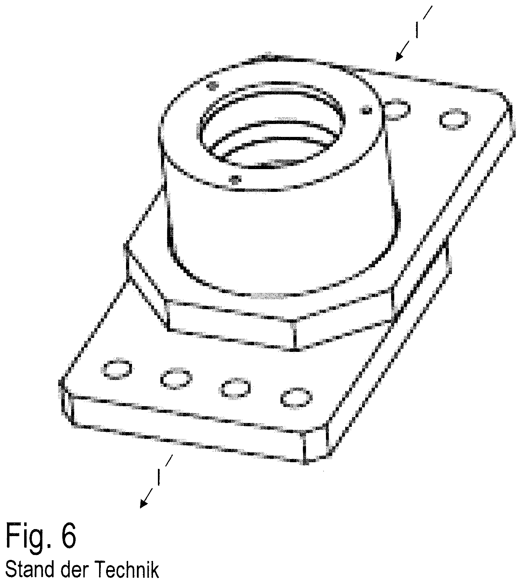

- Figur 6: eine Perspektivansicht eines herkömmlichen Koaxialwiderstands gemäß dem Stand der Technik.

Die Zeichnungen zeigen einen erfindungsgemäßen Koaxialwiderstand 1 zur Messung eines elektrischen Stroms I gemäß der bekannten Vierleitertechnik.

Der zu messende elektrische Strom I wird hierbei über ein plattenförmiges Anschlussteil 2 aus einem Leitermaterial (z.B. Kupfer) in den Koaxialwiderstand 1 eingeleitet und über ein ebenfalls plattenförmiges Anschlussteil 3 aus demselben Leitermaterial wieder aus dem Koaxialwiderstand 1 abgeführt.

In den beiden Anschlussteilen 2, 3 befinden sich jeweils Bohrungen 4 bzw. 5 zur Durchführung von Schrauben, so dass die beiden Anschlussteile 2, 3 beispielsweise mit Stromschienen verschraubt werden können.

Der zu messende elektrische Strom I fließt hierbei in Richtung der Pfeile von dem Anschlussteil 2 zunächst durch einen Hinleiter 6 und dann in entgegengesetzter Richtung durch einen Rückleiter 7, zu dem Anschlussteil 3. Der Hinleiter 6 und der Rückleiter 7 bestehen jeweils aus einem Leitermaterial (z.B. Kupfer) und führen den zu messenden elektrischen Strom I in entgegengesetzten Richtungen. Dies ist vorteilhaft, weil dadurch die von dem elektrischen Strom I in dem Hinleiter 6 einerseits und in dem Rückleiter 7 andererseits erzeugten Magnetfelder sich im Inneren wechselseitig weitgehend aufheben.

Der Hinleiter 6 besteht aus vier rechteckigen Platten, die rechtwinklig zu dem Anschlussteil 2 ausgerichtet und auf die Oberseite des Anschlussteils 2 aufgesetzt sind. Die rechteckigen Platten des Hinleiters 6 und des Rückleiters 7 sind hierbei durch Hartlötverbindungen 8a bzw. 8b mit der Oberseite des Anschlussteils 2 bzw. des Anschlussteils 3 verbunden.

An ihrer Oberseite sind die rechteckigen Platten des Hinleiters 6 ebenfalls durch eine Hartlötverbindung 9 mit den rechteckigen Platten des Rückleiters 7 verbunden.

Hierbei ist zu erwähnen, dass die rechteckigen Platten des Rückleiters 7 zweigeteilt sind und durch einen Spalt 10 unterteilt sind, wobei der Spalt 10 einen Stromfluss zwischen den beiden angrenzenden Teilen des Rückleiters 7 verhindert.

Der Spalt 10 wird hierbei durch Einlegeteile 11 überbrückt, die jeweils in einen Absatz in den angrenzenden Platten des Rückleiters 7 eingelegt und damit verbunden sind.

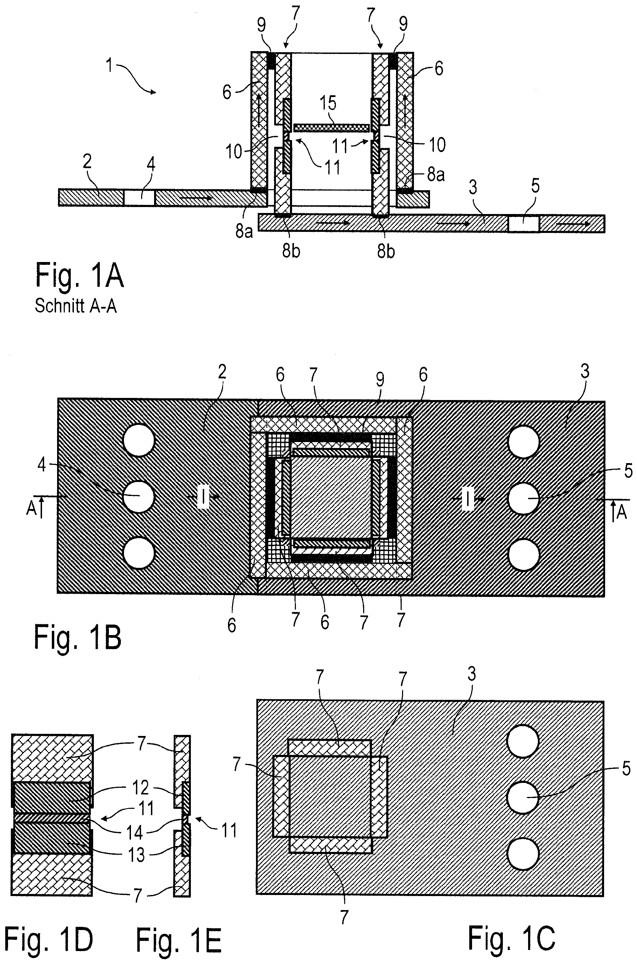

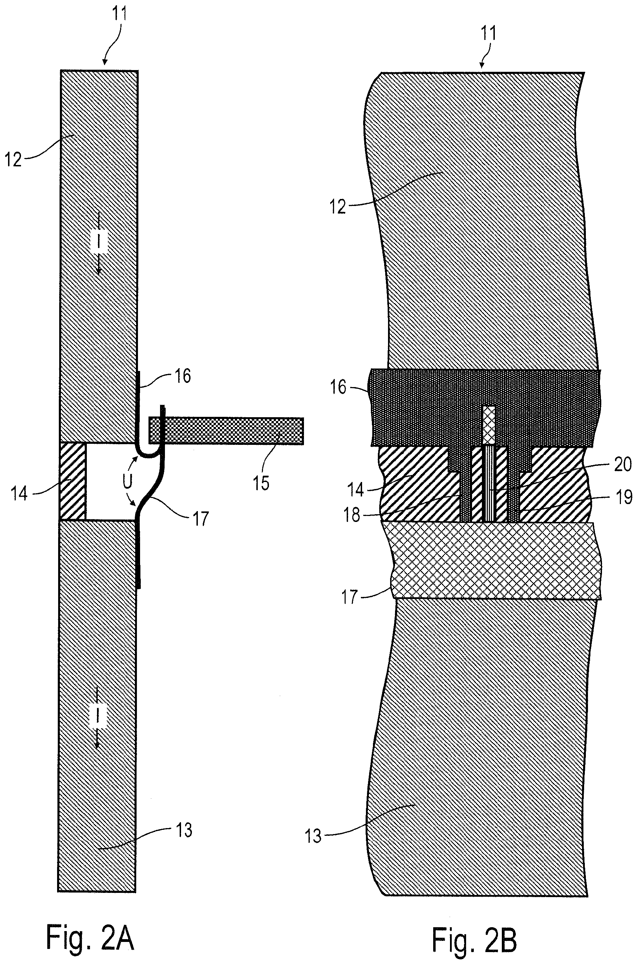

Die Einlegeteile 11 sind detailliert in den Figuren 1D und 1E dargestellt und bestehen aus zwei plattenförmigen Leiterelementen 12, 13 aus einem Leitermaterial (z.B. Kupfer) und einem dazwischen befindlichen Widerstandselement 14 aus einem Widerstandsmaterial (z.B. Manganin^{®}). Die Einlegeteile 12, 13 können beispielsweise aus einem Verbundmaterialband hergestellt werden, wie es beispielsweise aus EP 0 605 800 A1 bekannt ist. Der zu messende elektrische Strom I fließt also beim Durchströmen des Rückleiters durch die Einlegeteile 11 und damit auch durch das Widerstandselement 14. Der Spannungsabfall U (vgl. Fig. 2A) über dem Widerstandselement 14 der Einlegeteile 11 bildet also gemäß dem Ohm'schen Gesetz ein Maß für den zu messenden elektrischen Strom. Die Messung dieses Spannungsabfalls erfolgt über eine Messschaltung, die auf einer Leiterplatte 15 angeordnet ist, wobei die Leiterplatte 15 innerhalb des Rückleiters 7 angeordnet und rechtwinklig zur Stromflussrichtung ausgerichtet ist.

Wegen der zu erwartenden Inhomogenität der Stromverteilung innerhalb des Widerstandes wird eine Vielzahl von Paaren von Spannungsabgriffen ausgebildet, deren Messwerte in geeigneter Weise gemittelt werden.

In einer vereinfachten Ausführung für niedrigere Ströme bzw. hochohmigere Widerstandswerte kann das Einlegeteil den kompletten Rückleiter inklusive des Rückleiters 7 bilden.

Zur elektrischen Verbindung der Leiterplatte 15 mit den beiden plattenförmigen Anschlussteilen 12, 13 des Einlegeteils 11 sind zwei Stanzteile 16, 17 vorgesehen, wie insbesondere aus den Figuren 2A und 2B ersichtlich ist.

Die beiden Stanzteile 16, 17 sind bevorzugt durch jeweils eine Sinterverbindung mit den beiden plattenförmigen Anschlussteilen 12 bzw. 13 der Einlegeteile 11 verbunden. Hierzu wird zunächst eine Silber-Sinterpaste strukturiert auf die Leiterelemente 12, 13 gedruckt und getrocknet. Die Stanzteile 16, 17 werden dann passgenau in einem Niedertemperatur-Sinterprozess (250°-260°C) aufgebracht. Die gesinterte Verbindungsschicht besteht aus reinem Silber und ist je nach Druckdichte der Sinterpaste zwischen 30µm und 70µm dick. Diese Verbindung zwischen den Stanzteilen 16, 17 einerseits und den Leiterelementen 12, 13 andererseits übersteht auch den nachfolgenden Hartlötprozess, in dem der gesamte Koaxialwiderstand 1 verlötet wird, unbeschadet. Die Verbindung wird sogar noch stabiler durch eine intensive Diffusion von Kupfer und Silber. Die Verbindung kann aber auch als Schweiß-oder Hartlötverbindung ausgeführt werden.

Das spannungsseitige Stanzteil 16 weist hierbei zwei benachbarte Kontaktfahnen 18, 19 auf, wobei an dem masseseitigen Stanzteil 17 eine Kontaktfahne 20 angeformt ist, die mittig zwischen den beiden Kontaktfahnen 18, 19 des spannungsseitigen Stanzteils 16 verläuft. Die Kontaktfahnen 18-20 sind entsprechend gebogen, um die Leiterplatte 15 zu kontaktieren, wie insbesondere auf Figur 2A ersichtlich ist. Bei der Montage liegt die Leiterplatte 15 auf den Schultern der gebogenen Kontaktfahnen 18-20 als Positionierhilfe auf. Die Kontaktfahnen 18, 19 bilden also zusammen einen Spannungsabgriff auf der High-Seite (Spannungsabgriff), während die Kontaktfahne 20 einen Spannungsabgriff auf der Low-seite (Masseseite) bildet.

Die Vielzahl der Lötverbindungen zwischen der Leiterplatte 15 und den Einlegeteilen 11 garantiert dem Verbund aus der Leiterplatte 15 und dem Koaxialwiderstand 1 eine gute Festigkeit, wobei die gebogenen Kontaktfahnen 18-20 einen gewissen mechanischen Ausgleich bei den durch Temperaturwechsel möglichen Verspannungen erlauben.

Die doppelten Kontaktfahnen 18, 19 auf der Spannungsseite (High-Side) bieten den Vorteil, dass die Temperatur der Spannungsseite durch die gute Wärmeleitung über die Kontaktfahnen 18, 19 (doppelt, kurze Länge, breite Kontakte und sehr hohe Wärmeleifähigkeit) effektiv auf die Leiterplatte 15 übertragen wird. Damit liegt über der Verbundmaterialfahne 20 die volle Temperaturdifferenz des Shunts an, so dass die Thermospannungskompensation korrekt funktionieren kann.

Das masseseitige Stanzteil 17 besteht hierbei aus demselben Verbundmaterialband wie das Einlegeteil 11, um die unvermeidbaren Thermospannungen im Einlegeteil möglichst optimal kompensieren zu können. Vorzugsweise besteht das masseseitige Stanzteil 17 sogar aus derselben Charge desselben Verbundmaterialbands.

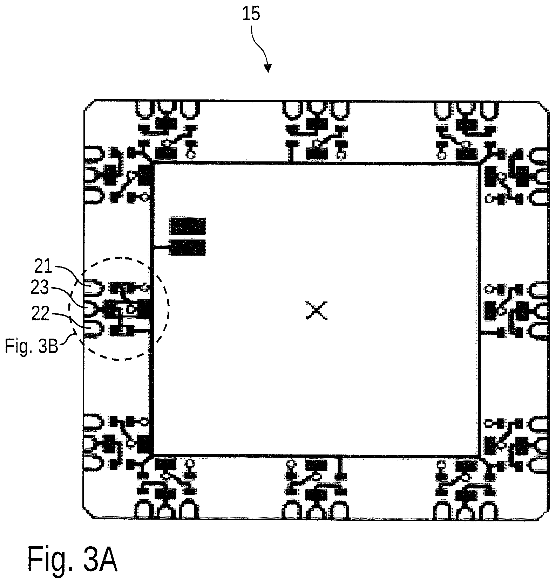

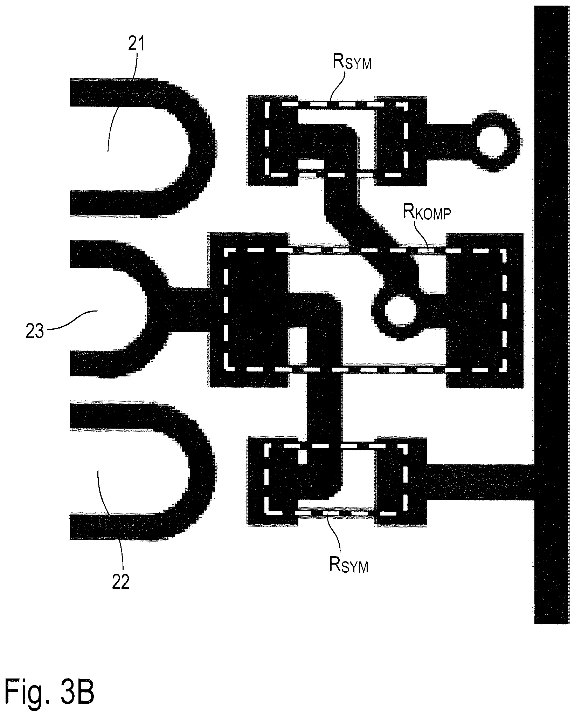

Die Figuren 3A und 3B zeigen Details der Leiterplatte 15. Fig. 3a zeigt, dass im realisierten Fall jeweils drei Paar von Spannungsabgriffen pro Einlegeteil 11 ausgebildet sind. Aus Figur 3B ist ersichtlich, dass die Leiterplatte 15 für jedes Paar von Spannungsabgriffen jeweils zwei Anschlussflächen 21, 22 für die Kontaktfahnen 18, 19 und eine mittige Anschlussfläche 23 für die Kontaktfahne 20 aufweist.

Weiterhin ist zu erwähnen, dass die Leiterplatte 15 mehrlagig ist und auf ihrer Oberseite Symmetrierungswiderstände R_{SYM} aufweist, wobei die Symmetrierwiderstände R_{SYM} die Aufgabe haben, die Spannungsmesswerte der einzelnen Paare von Spannungsabgriffen zu gewichten, wie es beispielsweise aus DE 10 2013 005 939 A1 bekannt ist.

Darüber hinaus trägt die Oberseite der Leiterplatte 15 noch einen Ausgleichswiderstand R_{KOMP} zur Kompensation der Temperaturabhängigkeit des Widerstandselementes, wie es beispielsweise aus DE 10 2016 008 415.4 bekannt ist.

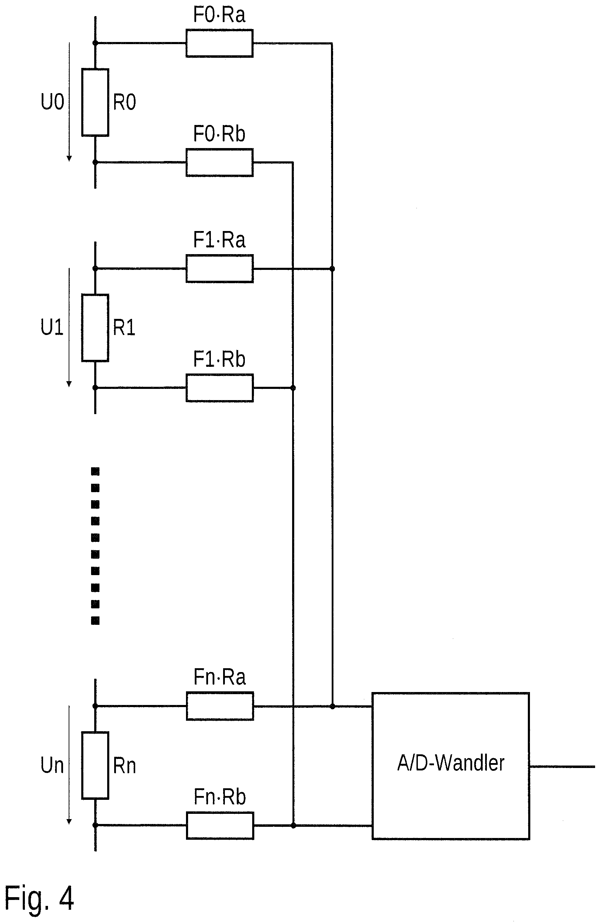

Figur 4 zeigt ein vereinfachtes Ersatzschaltbild zur Verdeutlichung der Gewichtung der einzelnen Spannungsmesswerte von den einzelnen Paaren von Spannungsabgriffen. Die Widerstände R0, R1, ..., Rn sind hierbei die Widerstandselemente 14 in den einzelnen Einlegeteilen 11. Die Widerstände Ra, Rb entsprechen dagegen den Symmetrierwiderständen R_{SYM} in Figur 3B. Die Funktionsweise dieser Schaltung ist beispielsweise in DE 10 2013 005 939 A1 beschrieben, so dass diesbezüglich auf diese frühere Patentanmeldung verwiesen wird.

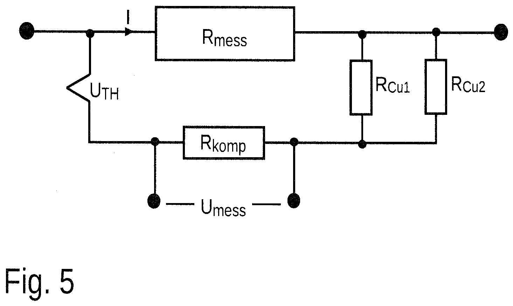

Schließlich zeigt Figur 5 ein Ersatzschaltbild zur Verdeutlichung der Kompensation von Thermospannungen Uth durch die Verbundmaterialfahne 20. Die Funktionsweise dieser Kompensation von Thermospannungen ist beispielsweise in DE 10 2016 008 415.4 beschrieben, so dass auch diesbezüglich auf diese frühere Patentanmeldung verwiesen werden kann.

Die Zeichnung zeigt auch zwei aus Kupfer bestehende und parallel geschaltete Widerstände R_{CU1} und R_{CU2}, die in einer zweiten Ebene der Leiterplatte 15 angeordnet sind und von spannungsseitigen Kupferanschlüssen ausgehen und als Temperaturfühler für die TK-Kompensation dienen. Zusätzlich nehmen die beiden Widerstände R_{CU1} und R_{CU2} eine Mittelwertbildung der beiden spannungsseitigen Potentialwerte vor.

### Bezugszeichenliste

- 1: Koaxialwiderstand
- 2: Plattenförmiges Anschlussteil zur Zuführung des Stroms
- 3: Plattenförmiges Anschlussteil zum Abführen des Stroms
- 4: Bohrung in dem Anschlussteil zum Festschrauben eines Anschlusskontakts
- 5: Bohrung in dem Anschlussteil zum Festschrauben eines Anschlusskontakts
- 6: Hinleiter
- 7: Rückleiter
- 8a: Hartlötverbindung zwischen Hinleiter und plattenförmigem Anschlussteil
- 8b: Hartlötverbindung zwischen Rückleiter und plattenförmigem Anschlussteil
- 9: Hartlötverbindung zwischen Hinleiter und Rückleiter
- 10: Spalt in dem Rückleiter
- 11: Einlegeteil aus Verbundmaterial in dem Rückleiter
- 12, 13: Plattenförmige Leiterelemente des Einlegeteils
- 14: Plattenförmiges Widerstandselement des Einlegeteils
- 15: Leiterplatte
- 16: Spannungsseitiges Stanzteil zum Spannungsabgriff
- 17: Masseseitiges Stanzteil zum Spannungsabgriff
- 18, 19: Kontaktfahnen des spannungsseitigen Stanzteils zur Kontaktierung der Leiterplatte
- 20: Kontaktfahne des masseseitigen Stanzteils zur Kontaktierung der Leiterplatte
- 21, 22: Anschlussflächen in der Leiterplatte für die spannungsseitigen Kontaktfahnen
- 23: Anschlussfläche in der Leiterplatte für die masseseitige Kontaktfahne
- I: Elektrischer Strom durch den Koaxialwiderstand
- Ra, Rb: Symmetrierwiderstände in der Leiterplatte
- R_{CU1}, R_{CU2}: Widerstände zur Kompensation der Temperaturabhängigkeit
- R_{KOMP}: Ausgleichswiderstand auf der Leiterplatte
- R0,...,Rn: Widerstandselemente
- R_{MESS}: Widerstandselement
- R_{SYM}: Symmetrierwiderstände auf der Leiterplatte
- U: Spannungsabfall über dem Widerstandselement
- U_{TH}: Thermospannung im masseseitigen Stanzteil aus Verbundmaterial
- U1,...,Un: Spannungsabfall über den Widerstandselementen R0,...,Rn

## Patentansprüche

1. Koaxialwiderstand (1) zur Messung eines elektrischen Stroms (I), mit
a) einem Hinleiter (6) zum Führen des zu messenden Stroms (I),
b) einem innerhalb des Hinleiters (6) liegenden Rückleiter (7) zum Führen des zu messenden Stroms (I), wobei der Hinleiter (6) und der Rückleiter (7) koaxial angeordnet und elektrisch in Reihe geschaltet sind und den Strom (I) in entgegengesetzten Stromflussrichtungen führen, und mit
c) einem Widerstandselement (14) aus einem Widerstandsmaterial, wobei das Widerstandselement (14) in dem Hinleiter (6) oder in dem Rückleiter (7) angeordnet ist, so dass der Strom (I) durch das Widerstandselement (14) fließt,
d) wobei der Querschnitt zumindest des innenliegenden Rückleiters (7) in einer Schnittebene rechtwinklig zu der Stromflussrichtung eckig ist,
e) wobei der außen liegende Hinleiter (6) aus mehreren ebenen, vorzugsweise rechteckigen Platten besteht,
**dadurch gekennzeichnet,**
f) dass der innen liegende Rückleiter (7) aus mehreren ebenen, vorzugsweise rechteckigen Platten besteht, und
g) dass die Platten des Hinleiters (6) einerseits und die Platten des Rückleiters (7) andererseits jeweils paarweise parallel zueinander angeordnet sind.

2. Koaxialwiderstand (1) nach Anspruch 1, **dadurch gekennzeichnet,**
a) **dass** die Platten des Hinleiters (6) oder die Platten des Rückleiters (7) das Widerstandselement (14) enthalten, und
b) **dass** das Widerstandselement (14) jeweils in einem Einlegeteil (11) enthalten ist, das in den Hinleiter (6) oder in den Rückleiter (7) eingelegt ist und einen quer zur Stromflussrichtung verlaufenden Spalt (10) in dem Hinleiter (6) oder dem Rückleiter (7) überbrückt, und
c) **dass** die Einlegeteile (11) jeweils aus einer Verbundmaterialplatte bestehen aus zwei plattenförmigen Leiterelementen (12, 13) aus einem Leitermaterial und dem in Stromflussrichtung dazwischen liegenden plattenförmigen Widerstandselement (14).

3. Koaxialwiderstand (1) nach einem der vorhergehenden Ansprüche, **gekennzeichnet durch**
a) ein erstes Anschlussteil (2) aus einem Leitermaterial zum Zuführen des Stroms (I) zu dem Koaxialwiderstand (1),
b) ein zweites Anschlussteil (3) aus einem Leitermaterial zum Abführen des Stroms (I) aus dem Koaxialwiderstand (1),
c) wobei der Hinleiter (6) und der Rückleiter (7) jeweils mit einem der beiden Anschlussteile (2, 3) elektrisch und mechanisch verbunden ist.

4. Koaxialwiderstand (1) nach Anspruch 3, **dadurch gekennzeichnet,**
a) **dass** die elektrische Verbindung zwischen dem Hinleiter (6) und dem Rückleiter (7) einerseits und den Anschlussteilen (2, 3) andererseits eine Lötverbindung, insbesondere eine Hartlötverbindung (8a, 8b), oder eine Schweißverbindung ist, und
b) **dass** die elektrische Verbindung zwischen dem Hinleiter (6) und dem Rückleiter (7) eine Hartlötverbindung (9) oder eine Schweißverbindung ist.

5. Koaxialwiderstand (1) nach Anspruch 3 oder 4, **dadurch gekennzeichnet,**
a) **dass** die beiden Anschlussteile (2, 3) aus ebenen, vorzugsweise rechteckigen Platten bestehen, und
b) **dass** die beiden plattenförmigen Anschlussteile (2, 3) rechtwinklig ausgerichtet sind zu den Platten des Hinleiters (6) und des Rückleiters (7).

6. Koaxialwiderstand (1) nach einem der vorhergehenden Ansprüche,
**dadurch gekennzeichnet,**
a) dass der Koaxialwiderstand (1) mehrere Widerstandselemente (14) aufweist,
b) dass zur Messung der über den Widerstandselementen (14) abfallenden elektrischen Spannungen jeweils mindestens ein Paar von Spannungsabgriffen (18, 19, 20) vorgesehen ist, und
b) dass mehrere Paare von Spannungsabgriffen (18, 19, 20) vorgesehen sind, wobei die Paare von Spannungsabgriffen (18, 19, 20) an verschiedenen Spannungsmesspunkten angeordnet sind, und
c) dass die Spannungsabgriffe (18, 19, 20) spannungsseitig oder masseseitig mindestens zwei Kontakte (18, 19) als Doppelabgriff aufweisen, um einen guten Wärmeübertrag auf eine Leiterplatte (15) zu erreichen.

7. Koaxialwiderstand (1) nach Anspruch 6, **dadurch gekennzeichnet,**
a) **dass** die Spannungsabgriffe (18, 19, 20) aus Kupfer bestehen, oder
b) die masseseitigen Spannungsabgriffe (20) aus demselben Verbundmaterial bestehen wie die Verbundmaterialplatte des Einlegeteils (11), insbesondere aus derselben Charge.

8. Koaxialwiderstand (1) nach Anspruch 7, **dadurch gekennzeichnet,**
a) **dass** zur Bildung der spannungsseitigen Spannungsabgriffe (18, 19) ein Stanzteil (16) vorgesehen ist, das mit dem spannungsseitigen plattenförmigen Leiterelement (12) des Einlegeteils (11) verbunden ist, und
b) **dass** zur Bildung der masseseitigen Spannungsabgriffe (20) ein Stanzteil (17) vorgesehen ist, das mit dem masseseitigen plattenförmigen Leiterelement (13) des Einlegeteils (11) verbunden ist.

9. Koaxialwiderstand (1) nach Anspruch 8, **dadurch gekennzeichnet,**
a) **dass** die Stanzteile (16, 17) zur elektrischen Verbindung mit einer Leiterplatte (15) Kontaktfahnen (18-20) haben, und
b) **dass** bei mindestens einem Paar der Spannungsabgriffe (18-20) eine masseseitige Kontaktfahne (20) mittig zwischen zwei spannungsseitigen Kontaktfahnen (18, 19) angeordnet ist.

10. Koaxialwiderstand (1) nach Anspruch 8 oder 9, **dadurch gekennzeichnet,**
a) **dass** die Stanzteile (16, 17) jeweils durch eine der folgenden Verbindungen mit den plattenförmigen Leiterelementen (12, 13) der Einlegeteile (11) verbunden sind:
a1) eine Sinterverbindung,
a2) eine Lötverbindung, insbesondere eine Hartlötverbindung,
a3) eine Schweißverbindung, und
b) **dass** die Sinterverbindung mittels einer Silber-Sinterpaste erfolgt, und
c) **dass** die Sinterverbindung eine gesinterte Schicht mit einer Schichtdicke von 30µm bis 70µm aufweist.

11. Koaxialwiderstand (1) nach einem der Ansprüche 8 bis 10, **dadurch gekennzeichnet,**
a) **dass** die Stanzteile (16, 17) eine Dicke von mehr als 0,1mm und weniger als 2 mm aufweisen, und/oder
b) **dass** eines der Stanzteile (16, 17) und die Verbundmaterialplatten des Einlegeteils (11) aus demselben Verbundmaterial bestehen, insbesondere aus derselben Charge eines Verbundmaterialbands.

12. Koaxialwiderstand (1) nach einem der vorhergehenden Ansprüche,
**dadurch gekennzeichnet,**
a) **dass** innen zwischen dem Hinleiter (6) und dem Rückleiter (7) eine Messschaltung angeordnet ist, welche die über dem Widerstandselement (14) abfallende Spannung erfasst, und
b) **dass** die Messschaltung auf einer Leiterplatte (15) angeordnet ist, und
c) **dass** die Leiterplatte (15) mit den Kontaktfahnen (18-20) der Stanzteile (16, 17) verbunden ist, und
d) **dass** die Leiterplatte (15) quer, insbesondere rechtwinklig, zu der Stromflussrichtung in dem Hinleiter (6) und dem Rückleiter (7) angeordnet ist, und
e) **dass** die Leiterplatte (15) an mindestens einer seitlichen Stirnkante Anschlüsse (21, 22, 23) zur Verbindung mit den Spannungsabgriffen (18, 19, 20) aufweist, und
f) **dass** die Leiterplatte (15) an allen seitlichen Stirnkanten Anschlüsse (21, 22, 23) aufweist zur Verbindung mit den Spannungsabgriffen (18, 19, 20) der parallelen Einlegeteile (11).

13. Koaxialwiderstand (1) nach Anspruch 12, **dadurch gekennzeichnet,**
a) **dass** eine erste Leiterplattenebene, insbesondere die Oberseite der Leiterplatte (15), Symmetrierwiderstände (R_{SYM}, Ra, Rb) enthält, wobei die Symmetrierwiderstände (R_{SYM}, Ra, Rb) jeweils den einzelnen Paaren von Spannungsabgriffen (18, 19, 20) zugeordnet sind, um die einzelnen Spannungsmesswerte zu gewichten, und
b) **dass** die erste Leiterplattenebene einen Widerstand (Rₖₒₘₚ) zur Kompensation der Temperaturabhängigkeit des Widerstandselementes enthält, und
c) **dass** eine zweite Leiterplattenebene einen Widerstand (R_{CU1}, Rcuz) aus Kupfer enthält, der als Temperaturfühler für eine Kompensation der Temperaturabhängigkeit des Widerstandselementes (14) dient, und
d) **dass** der aus Kupfer bestehende Widerstand (R_{CU1}, R_{CU2}) zur Temperaturkompensation aus zwei parallel geschalteten Widerständen (R_{Cu1}, R_{Cu2}) besteht, die eine Mittelwertbildung der beiden Mess-Spannungen aus dem Doppelabgriffen bilden, und
e) **dass** eine dritte Leiterplattenebene und eine vierte Leiterplattenebene, insbesondere die Unterseite der Leiterplatte (15), Kupferanschlussflächen zum Wärmeausgleich im Bereich der Kupfer-Widerstände (R_{Cu1}, R_{Cu2}) aufweist.

14. Koaxialwiderstand (1) nach einem der vorhergehenden Ansprüche,
**dadurch gekennzeichnet,**
a) **dass** der Koaxialwiderstand (1) eine Dauerstromfestigkeit von mindestens 1kA aufweist, und
b) **dass** das Leitermaterial Kupfer oder eine Kupferlegierung oder Aluminium oder eine Aluminiumlegierung ist, und
c) **dass** das Leitermaterial eine größere spezifische elektrische Leitfähigkeit aufweist als das Widerstandsmaterial, und
d) **dass** das Widerstandsmaterial eine Kupfer-Mangan-Legierung ist, insbesondere eine Kupfer-Mangan-Nickel-Legierung, oder eine Nickel-Chrom-Legierung, und
e) **dass** das Widerstandsmaterial des Widerstandselements (14) einen spezifischen elektrischen Widerstand aufweist, der
e1) kleiner als 50·10⁻⁷ Ωm und
e2) größer als 1·10⁻⁸ Ωm ist, und
f) **dass** der Koaxialwiderstand (1) einen Widerstandswert aufweist, der
f1) mindestens 0,1 µΩ und
f2) höchstens 1000 µΩ beträgt, und
g) **dass** der Koaxialwiderstand (1) einen Widerstandswert mit einem Temperaturkoeffizienten von weniger als 500 ppm/K aufweist.

## Claims

1. Coaxial resistor (1) for measuring an electric current (I), comprising
a) a forward conductor (6) for conducting the current (I) to be measured,
b) a return conductor (7) located inside the forward conductor (6) for conducting the current (I) to be measured, the forward conductor (6) and the return conductor (7) being arranged coaxially and electrically connected in series and conducting the current (I) in opposite current flow directions, and having
c) a resistor element (14) made of a resistance material, the resistor element (14) being arranged in the forward conductor (6) or in the return conductor (7) so that the current (I) flows through the resistor element (14),
d) wherein the cross-section of at least the internal return conductor (7) in a section plane perpendicular to the current flow direction is angular,
e) wherein the external forward conductor (6) consists of a plurality of flat, preferably rectangular plates,
**characterised in**
f) that the internal return conductor (7) consists of a plurality of flat, preferably rectangular plates, and
g) that the plates of the forward conductor (6) on the one hand and the plates of the return conductor (7) on the other hand are each arranged in pairs parallel to one another.

2. Coaxial resistor (1) according to claim 1, **characterised in**
a) **that** the plates of the forward conductor (6) or the plates of the return conductor (7) contain the resistor element (14), and
b) **that** the resistor element (14) is in each case contained in an insert (11) which is inserted in the forward conductor (6) or in the return conductor (7) and bridges a gap (10) in the forward conductor (6) or the return conductor (7), which runs transversely to the current flow direction, and
c) **that** the inserts (11) each consist of a composite material plate comprising two plate-shaped conductor elements (12, 13) of a conductor material and the plate-shaped resistor element (14) lying between them in the current flow direction.

3. Coaxial resistor (1) according to one of the preceding claims, **characterized by**
a) a first connection part (2) made of a conductor material for supplying the current (I) to the coaxial resistor (1),
b) a second connection part (3) made of a conductor material for removing the current (I) from the coaxial resistor (1),
c) the forward conductor (6) and the return conductor (7) each being electrically and mechanically connected to one of the two connection parts (2, 3).

4. Coaxial resistor (1) according to Claim 3, **characterized in**
a) **that** the electric connection between the forward conductor (6) and the return conductor (7) on the one hand and the connection parts (2, 3) on the other hand is a soldered connection, in particular a brazed connection (8a, 8b), or a welded connection, and
b) **that** the electric connection between the forward conductor (6) and the return conductor (7) is a brazed joint (9) or a welded joint.

5. Coaxial resistor (1) according to claim 3 or 4, **characterised in**
a) **that** the two connection parts (2, 3) consist of flat, preferably rectangular plates, and
b) **that** the two plate-shaped connection parts (2, 3) are aligned at right angles to the plates of the forward conductor (6) and of the return conductor (7).

6. Coaxial resistor (1) according to one of the preceding claims, **characterized in**
a) that the coaxial resistor (1) comprises several resistor elements (14),
b) that at least one pair of voltage taps (18, 19, 20) is provided in each case for measuring the electric voltages falling over the resistor elements (14), and
b) that a plurality of pairs of voltage taps (18, 19, 20) are provided, the pairs of voltage taps (18, 19, 20) being arranged at different voltage measuring points, and
c) that the voltage taps (18, 19, 20) have at least two contacts (18, 19) as double taps on the voltage and ground side in order to achieve good heat transfer to a printed circuit board (15).

7. Coaxial resistor (1) according to claim 6, **characterised in**
a) **that** the voltage taps (18, 19, 20) consist of copper, or
b) **that** the mass-side voltage taps (20) consist of the same composite material as the composite material plate of the insert (11), in particular of the same batch.

8. Coaxial resistor (1) according to claim 7, **characterised in**
a) **that** a punched part (16) is provided for forming the voltage-side voltage taps (18, 19), which punched part is connected to the voltage-side plate-shaped conductor element (12) of the insert (11), and
b) **that** a punched part (17), which is connected to the plate-shaped conductor element (13) of the insert (11) on the mass-side, is provided in order to form the voltage taps (20) on the mass-side.

9. Coaxial resistor (1) according to Claim 8, **characterized in**
a) **that** the punched parts (16, 17) have contact lugs (18-20) for electric connection to a printed circuit board (15), and
b) **that** in at least one pair of the voltage taps (18-20) a ground-side contact lug (20) is arranged centrally between two voltage-side contact lugs (18, 19).

10. Coaxial resistor (1) according to Claim 8 or 9, **characterized in**
a) **that** the punched parts (16, 17) are each connected to the plate-shaped conductor elements (12, 13) of the inserts (11) by one of the following connections:
a1) a sintered connection,
a2) a soldered joint, in particular a brazed joint,
a3) a welded joint, and
b) **that** the sintered connection is made by means of a silver sinter paste; and
c) **that** the sintered connection comprises a sintered layer having a layer thickness of 30µm to 70µm.

11. Coaxial resistor (1) according to any one of claims 8 to 10, **characterized in**
a) **that** the punched parts (16, 17) have a thickness of more than 0.1mm and less than 2mm, and/or
b) **that** one of the punched parts (16, 17) and the composite material plates of the insert (11) consist of the same composite material, in particular of the same batch of a composite material strip.

12. Coaxial resistor (1) according to one of the preceding claims, **characterized in**
a) **that** a measuring circuit is arranged on the inside between the forward conductor (6) and the return conductor (7), which measuring circuit detects the voltage which drops over the resistor element (14), and
b) **that** the measuring circuit is arranged on a printed circuit board (15), and
c) **that** the printed circuit board (15) is connected to the contact lugs (18-20) of the punched parts (16, 17), and
d) **that** the printed circuit board (15) is arranged transversely, in particular at right angles, to the current flow direction in the forward conductor (6) and the return conductor (7), and
e) **that** the printed circuit board (15) has terminals (21, 22, 23) on at least one lateral end edge for connection to the voltage taps (18, 19, 20), and
f) **that** the printed circuit board (15) has terminals (21, 22, 23) on all lateral end edges for connection to the voltage taps (18, 19, 20) of the parallel inserts (11).

13. Coaxial resistor (1) according to claim 12, **characterised in**
a) **that** a first printed circuit board plane, in particular the upper side of the printed circuit board (15), contains balancing resistors (R_{SYM}, Ra, Rb), the balancing resistors (R_{SYM}, Ra, Rb) each being assigned to the individual pairs of voltage taps (18, 19, 20) in order to weight the individual voltage measured values, and
b) **that** the first printed circuit board plane contains a resistor (Rₖₒₘₚ) for compensating the temperature dependence of the resistor element, and
c) **that** a second printed circuit board plane contains a resistor (R_{CU1}, R_{CU2}) made of copper which serves as a temperature sensor for compensating the temperature dependence of the resistor element (14), and
d) **that** the copper resistor (R_{CU1}, R_{CU2}) for temperature compensation consists of two resistors (R_{Cu1}, _{RCu2}) which are connected in parallel and form an average value of the two measuring voltages from the double tap, and
e) **that** a third printed circuit board plane and a fourth printed circuit board plane, in particular the underside of the printed circuit board (15), have copper connection surfaces for heat compensation in the region of the copper resistors (R_{Cu1}, R_{Cu2}).

14. Coaxial resistor (1) according to one of the preceding claims, **characterized in**
a) **that** the coaxial resistor (1) has a continuous current carrying capability of at least 1kA, and
b) **that** the conductor material is copper or copper alloy or aluminium or aluminium alloy; and
c) **that** the conductor material has a higher specific electric conductivity than the resistance material; and
d) **that** the resistance material is a copper-manganese alloy, in particular a copper-manganese-nickel alloy, or a nickel-chromium alloy, and
e) **that** the resistance material of the resistor element (14) has a resistive electric resistance which is
e1) less than 50·10⁻⁷ Ωm, and
e2) is greater than 1·10⁻⁸ Ωm; and
f) **that** the coaxial resistor (1) has a resistance value which is
f1) at least 0.1 µΩ and
f2) a maximum of 1000 µΩ, and
g) **that** the coaxial resistor (1) has a resistance value with a temperature coefficient of less than 500 ppm/K.

## Revendications

1. Résistance coaxiale (1) pour mesurer un courant électrique (I), avec
a) un conducteur aller (6) pour acheminer le courant (1) à mesurer,
b) un conducteur retour (7) situé à l'intérieur du conducteur aller (6), pour acheminer le courant (1) à mesurer, dans laquelle le conducteur aller (6) et le conducteur retour (7) sont disposés de manière coaxiale et sont branchés électriquement en série et acheminent le courant (I) dans des directions de circulation de courant opposées, et avec
c) un élément de résistance (14) composé d'un matériau de résistance, dans laquelle l'élément de résistance (14) est disposé dans le conducteur aller (6) ou dans le conducteur retour (7) de sorte que le courant (I) circule à travers l'élément de résistance (14),
d) dans laquelle la section transversale au moins du conducteur retour (7) situé à l'intérieur est polygonale dans un plan de coupe à angle droit par rapport à la direction de circulation de courant,
e) dans laquelle le conducteur aller (6) situé à l'extérieur est constitué de plusieurs plaques plates, de préférence rectangulaires,
**caractérisée en ce**
f) que le conducteur retour (7) situé à l'intérieur est constitué de plusieurs plaques plates, de préférence rectangulaires, et
g) que les plaques du conducteur aller (6) d'une part et les plaques du conducteur retour (7) d'autre part sont disposées respectivement par paire de manière parallèle les unes par rapport aux autres.

2. Résistance coaxiale (1) selon la revendication 1, **caractérisée en ce**
a) **que** les plaques du conducteur aller (6) ou les plaques du conducteur retour (7) contiennent l'élément de résistance (14), et
b) **que** l'élément de résistance (14) est contenu respectivement dans une partie d'insertion (11), qui est insérée dans le conducteur aller (6) ou dans le conducteur retour (7) et surmonte une fente (10) s'étendant de manière transversale par rapport à la direction de circulation de courant dans le conducteur aller (6) ou dans le conducteur retour (7), et
c) **que** les parties d'insertion (11) sont constituées respectivement d'une plaque de matériau composite composée de deux éléments conducteurs en forme de plaque (12, 13) composés d'un matériau conducteur et de l'élément de résistance (14) en forme de plaque intercalé dans la direction de circulation de courant.

3. Résistance coaxiale (1) selon l'une quelconque des revendications précédentes, **caractérisée par**
a) une première partie de connexion (2) composée d'un matériau conducteur pour amener le courant (I) à la résistance coaxiale (1),
b) une deuxième partie de connexion (3) composée d'un matériau conducteur pour évacuer le courant (1) hors de la résistance coaxiale (1),
c) dans laquelle le conducteur aller (6) et le conducteur retour (7) sont raccordés électriquement et mécaniquement respectivement à une des deux parties de connexion (2, 3).

4. Résistance coaxiale (1) selon la revendication 3, **caractérisée en ce**
a) **que** le raccordement électrique entre le conducteur aller (6) et le conducteur retour (7) d'une part et les parties de connexion (2, 3) d'autre part est un raccordement par brasage, en particulier un raccordement par brasage fort (8a, 8b) ou un raccordement par soudage, et
b) **que** le raccordement électrique entre le conducteur aller (6) et le conducteur retour (7) est un raccordement par brasage fort (9) ou un raccordement par soudage.

5. Résistance coaxiale (1) selon la revendication 3 ou 4, **caractérisée en ce**
a) **que** les deux parties de connexion (2, 3) sont constituées de plaques plates, de préférence rectangulaires, et
b) **que** les deux parties de connexion (2, 3) en forme de plaque sont orientées à angle droit par rapport aux plaques du conducteur aller (6) et du conducteur retour (7) .

6. Résistance coaxiale (1) selon l'une quelconque des revendications précédentes,
**caractérisée en ce**
a) que la résistance coaxiale (1) présente plusieurs éléments de résistance (14),
b) que respectivement au moins une paire de prises de tension (18, 19, 20) est prévue pour mesurer les tensions électriques chutant dans des éléments de résistance (14),
et
b) que plusieurs paires de prises de tension (18, 19, 20) sont prévues, dans laquelle les paires de prises de tension (18, 19, 20) sont disposées sur différents points de mesure de tension, et
c) que les prises de tension (18, 19, 20) présentent côté tension ou côté masse au moins deux contacts (18, 19) en tant que double prise pour atteindre un transfert de chaleur satisfaisant sur une carte de circuits imprimés (15).

7. Résistance coaxiale (1) selon la revendication 6, **caractérisée en ce**
a) **que** les prises de tension (18, 19, 20) sont constituées de cuivre, ou
b) les prises de tension (20) côté masse sont constituées du même matériau composite que la plaque de matériau composite de la partie d'insertion (11), en particulier du même lot.

8. Résistance coaxiale (1) selon la revendication 7, **caractérisée en ce**
a) **qu'**est prévue pour former les prises de tension (18, 19) côté tension une partie estampée (16), qui est raccordée à l'élément conducteur (12) en forme de plaque côté tension de la partie d'insertion (11), et
b) **qu'**est prévue pour former les prises de tension (20) côté masse une partie estampée (17), qui est raccordée à l'élément conducteur (13) en forme de plaque côté masse de la partie d'insertion (11).

9. Résistance coaxiale (1) selon la revendication 8, **caractérisée en ce**
a) **que** les parties estampées (16, 17) ont des languettes de contact (18 - 20) pour le raccordement électrique à une carte de circuits imprimés (15), et
b) **que** pour au moins une paire des prises de tension (18 - 20), une languette de contact (20) côté masse est disposée au centre entre deux languettes de contact (18, 19) côté tension.

10. Résistance coaxiale (1) selon la revendication 8 ou 9, **caractérisée en ce**
a) **que** les parties estampées (16, 17) sont raccordées aux éléments conducteurs (12, 13) en forme de plaque des parties d'insertion (11) respectivement par un des raccordements suivants :
a1) un raccordement par frittage,
a2) un raccordement par brasage, en particulier un raccordement par brasage fort,
a3) un raccordement par soudage, et
b) **que** le raccordement par frittage est effectué au moyen d'une pâte de frittage en argent, et
c) **que** le raccordement par frittage présente une couche frittée avec une épaisseur de couche de 30 µm à 70 µm.

11. Résistance coaxiale (1) selon l'une quelconque des revendications 8 à 10, **caractérisée en ce**
a) **que** les parties estampées (16, 17) présentent une épaisseur supérieure à 0,1 mm et inférieure à 2 mm,
et/ou
b) **qu'**une des parties estampées (16, 17) et les plaques de matériau composite de la partie d'insertion (11) sont constituées du même matériau composite, en particulier du même lot d'une bande de matériau composite.

12. Résistance coaxiale (1) selon l'une quelconque des revendications précédentes,
**caractérisée en ce**
a) **qu'**un circuit de mesure est disposé à l'intérieur entre le conducteur aller (6) et le conducteur retour (7), lequel détecte la tension chutant dans l'élément de résistance (14), et
b) **que** le circuit de mesure est disposé sur une carte de circuits imprimés (15), et
c) **que** la carte de circuits imprimés (15) est raccordée aux languettes de contact (18-20) des parties estampées (16, 17), et
d) **que** la carte de circuits imprimés (15) est disposée de manière transversale, en particulier à angle droit, par rapport à la direction de circulation de courant dans le conducteur aller (6) et le conducteur retour (7), et
e) **que** la carte de circuits imprimés (15) présente sur au moins une arête frontale latérale des connexions (21, 22, 23) destinées à être raccordées aux prises de tension (18, 19, 20), et
f) **que** la carte de circuits imprimés (15) présente sur toutes les arêtes frontales latérales des connexions (21, 22, 23) destinées à être raccordées aux prises de tension (18, 19, 20) des parties d'insertion (11) parallèles.

13. Résistance coaxiale (1) selon la revendication 12, **caractérisée en ce**
a) **qu'**un premier plan de carte de circuits imprimés, en particulier le côté supérieur de la carte de circuits imprimés (15), contient des résistances de symétrisation (R_{SYM}, Ra, Rb), dans laquelle les résistances de symétrisation (R_{SYM}, Ra, Rb) sont associées respectivement aux diverses paires de prises de tension (18, 19, 20) pour pondérer les diverses valeurs de mesure de tension, et
b) **que** le premier plan de carte de circuits imprimés contient une résistance (Rₖₒₘₚ) pour compenser la dépendance à la température de l'élément de résistance, et
c) **qu'**un deuxième plan de carte de circuits imprimés contient une résistance (R_{CU1}, R_{CU2}) en cuivre, qui fait office de sonde de température pour une compensation de la dépendance à la température de l'élément de résistance (14), et
d) **que** la résistance (R_{CU1}, R_{CU2}) constituée de cuivre pour la compensation de température est constituée de deux résistances (R_{CU1}, R_{CU2}) branchées en parallèle, qui forment un calcul de valeur moyenne des deux tensions de mesure issues de la double prise, et
e) **qu'**un troisième plan de cartes de circuit imprimé et un quatrième plan de carte de circuits imprimés, en particulier le côté inférieur de la carte de circuits imprimés (15), présentent des surfaces de connexion en cuivre pour l'équilibre thermique dans la zone des résistances en cuivre (R_{CU1}, R_{CU2}).

14. Résistance coaxiale (1) selon l'une quelconque des revendications précédentes,
**caractérisée en ce**
a) **que** la résistance coaxiale (1) présente une résistance au courant permanent d'au moins 1 kA,
et
b) **que** le matériau conducteur est du cuivre ou un alliage de cuivre ou de l'aluminium ou un alliage d'aluminium, et
c) **que** le matériau conducteur présente une conductivité électrique spécifique plus importante que le matériau de résistance, et
d) **que** le matériau de résistance est un alliage de cuivre-manganèse, en particulier un alliage de cuivre-manganèse-nickel, ou un alliage de nickel-chrome, et
e) **que** le matériau de résistance de l'élément de résistance (14) présente une résistance électrique spécifique, qui
e1) est inférieure à 50.10⁻⁷ Ωm et
e2) est supérieure à 1.10⁻⁸ Ωm, et
f) **que** la résistance coaxiale (1) présente une valeur de résistance, qui
f1) est d'au moins 0,1 µΩ et
f2) de 1000 µΩ au maximum, et
g) **que** la résistance coaxiale (1) présente une valeur de résistance avec un coefficient de température inférieur à 500 ppm/K.
